# EUROPEAN PATENT APPLICATION

(11) **EP 4 447 135 A1**
(43) Date of publication of application: **16.10.2024**
(21) Application number: 22904196.7
(22) Date of filing: 05.12.2022
(51) Int. Cl.: H01L 33/32

(54) **ULTRAVIOLET LIGHT EMITTING ELEMENT AND MANUFACTURING METHOD THEREFOR**

(30) Priority: 07.12.2021 JP 2021198845; 02.12.2022 JP 2022193814
(71) Applicant: DOWA Electronics Materials Co., Ltd., Tokyo 101-0021 (JP)
(72) Inventor: WATANABE, Yasuhiro, Tokyo 101-0021 (JP)
(74) Representative: Müller-Boré & Partner Patentanwälte PartG mbB
(86) International application number: PCT/JP2022/044791
(87) International publication number: WO 2023/106268

(57) **Abstract**

Provided are an ultraviolet light-emitting element that enables high light emission output with a central emission wavelength of more than 320 nm and less than 350 nm and a method of producing the same. The light-emitting element (100) includes, in stated order: an n-type semiconductor layer (3) formed of AlₓGa₁₋ₓN having an Al composition ratio x; a quantum well-type light-emitting layer (4); a p-type electron blocking layer (6) formed of Al_{y}Ga_{1-y}N having an Al composition ratio y; a p-type cladding layer (7) formed of Al_{z}Ga_{1-z}N having an Al composition ratio z; and a p-type GaN contact layer (8). The p-type electron blocking layer (6) has an Al composition ratio y of 0.35 to 0.45 and a thickness of 11 nm to 70 nm. The total thickness of the p-type electron blocking layer (6) and p-type cladding layer (7) is 73 nm to 100 nm. The thickness of the p-type GaN contact layer (8) is 5 nm to 15 nm.

## Description

### TECHNICAL FIELD

The present disclosure relates to an ultraviolet light-emitting element and a method of producing the same.

### BACKGROUND

Light-emitting elements having aluminum gallium nitride (AlGaN) as a main constituent are capable of emitting light of approximately 250 nm to 360 nm. Since ultraviolet light-emitting elements having a central emission wavelength corresponding to UVC (up to 280 nm) or UVB (280 nm to 320 nm) are used for sterilization and the like, there has been particularly active development of deep ultraviolet light-emitting elements for these wavelength regions.

Patent Literature (PTL) 1 describes a light-emitting element that emits deep ultraviolet light of 240 nm to 320 nm. PTL 1 discloses that in this light-emitting element, it is preferable that an electron blocking layer has a thickness of 1 nm to 10 nm, a p-type cladding layer has a thickness of 10 nm to 100 nm, and a p-type contact layer has a thickness of more than 500 nm. PTL 1 also discloses that flatness of the p-type contact layer can be improved by increasing the thickness of the p-type contact layer.

PTL 2 describes a nitride semiconductor ultraviolet light-emitting element. PTL 2 discloses that in this light-emitting element, output is improved through an active layer having a rougher surface to the extent that the average roughness thereof is not less than the thickness of a well layer. PTL 2 also gives an example in which an electron blocking layer is 15 nm to 30 nm, a p-type cladding layer to 500 nm to 600 nm, and a p-type contact layer is 100 nm to 300 nm.

PTL 3 describes an ultraviolet light-emitting element and a method of producing the same. PTL 3 discloses that in this ultraviolet light-emitting element, the thickness of an electron blocking layer is set as 1 nm to 50 nm and the Al composition of the electron blocking layer is set as 50% or more in a case in which the wavelength is shorter than 350 nm.

### CITATION LIST

### Patent Literature

| | |
|---|---|
| PTL 1: | JP06814902B1 |
| PTL 2: | WO2017/013729A1 |
| PTL 3: | JP2017-050439A |

### SUMMARY

### (Technical Problem)

Although there have been numerous reports relating to ultraviolet light-emitting elements having a central emission wavelength corresponding to UVC (up to 280 nm) or UVB (280 nm to 320 nm), there have been few reports relating to UVA (upwards of 320 nm) ultraviolet light-emitting elements. There are instances in which UVA (upwards of 320 nm) ultraviolet light-emitting elements are used for curing of resins, medicinal applications, and analytical applications. Therefore, there is demand for the provision of ultraviolet light-emitting elements that are suitable for UVA. In particular, there is demand for the provision of an ultraviolet light-emitting element that enables high light emission output with a central emission wavelength of more than 330 nm and less than 350 nm.

The present disclosure is made in light of the circumstances set forth above, and an object thereof is to provide an ultraviolet light-emitting element that enables high light emission output with a central emission wavelength of more than 320 nm and less than 350 nm, and in particular more than 330 nm and less than 350 nm, and also to provide a method of producing the same.

### (Solution to Problem)

Ultraviolet light-emitting elements according to the present disclosure for achieving the object set forth above are as follows.
(1) An ultraviolet light-emitting element comprising, in stated order:
   an n-type semiconductor layer formed of AlₓGa₁₋ₓN having an Al composition ratio x;
   a quantum well-type light-emitting layer;
   a p-type electron blocking layer formed of Al_{y}Ga_{1-y}N having an Al composition ratio y;
   a p-type cladding layer formed of Al_{z}Ga_{1-z}N having an Al composition ratio z; and
   a p-type GaN contact layer, wherein
   the Al composition ratio y of the p-type electron blocking layer is not less than 0.35 and not more than 0.45,
   a thickness of the p-type electron blocking layer is not less than 11 nm and not more than 70 nm,
   a total thickness of the p-type electron blocking layer and the p-type cladding layer is not less than 73 nm and not more than 100 nm, and
   a thickness of the p-type GaN contact layer is not less than 5 nm and not more than 15 nm.
(2) The ultraviolet light-emitting element according to the foregoing (1), wherein
   a surface of the p-type GaN contact layer has:
   a maximum surface roughness of 9 nm or less; and
   an average surface roughness of 1 nm or less.
(3) The ultraviolet light-emitting element according to the foregoing (1) or (2), wherein the Al composition ratio z of the p-type cladding layer is not less than 0.17 and not more than 0.27.
(4) The ultraviolet light-emitting element according to any one of the foregoing (1) to (3), wherein a value obtained by dividing a thickness of the p-type cladding layer by the thickness of the p-type electron blocking layer is 0.4 or more.
(5) The ultraviolet light-emitting element according to any one of the foregoing (1) to (4), wherein a surface of the n-type semiconductor layer has an average surface roughness of 1 nm or less.
(6) The ultraviolet light-emitting element according to any one of the foregoing (1) to (5), wherein the n-type semiconductor layer has a full width at half maximum for (10-12) planes according to X-ray diffraction of 350 seconds or less.
(7) The ultraviolet light-emitting element according to any one of the foregoing (1) to (6), wherein
   the Al composition ratio x of the n-type semiconductor layer is not less than 0.2 and not more than 0.35, and
   the Al composition ratio z of the p-type cladding layer is not more than the Al composition ratio x of the n-type semiconductor layer.
(8) The ultraviolet light-emitting element according to any one of the foregoing (1) to (7), further comprising a reflective electrode, wherein the reflective electrode is disposed on a surface of the p-type GaN contact layer at an opposite side thereof to a surface at a side facing toward the p-type cladding layer.
(9) The ultraviolet light-emitting element according to any one of the foregoing (1) to (8), having a central emission wavelength of not less than 331 nm and not more than 349 nm.
   Moreover, methods of producing an ultraviolet light-emitting element according to the present disclosure for achieving the object set forth above are as follows.
(10) A method of producing an ultraviolet light-emitting element comprising:
   an n-type semiconductor layer formation step of forming an n-type semiconductor layer formed of AlₓGa₁₋ₓN having an Al composition ratio x;
   a light-emitting layer formation step of forming a quantum well-type light-emitting layer;
   a p-type electron blocking layer formation step of forming a p-type electron blocking layer formed of Al_{y}Ga_{1-y}N having an Al composition ratio y;
   a p-type cladding layer formation step of forming a p-type cladding layer formed of Al_{z}Ga_{1-z}N having an Al composition ratio z; and
   a p-type GaN contact layer formation step of forming a p-type GaN contact layer, wherein
   the n-type semiconductor layer formation step, the light-emitting layer formation step, the p-type electron blocking layer formation step, the p-type cladding layer formation step, and the p-type GaN contact layer formation step are performed in stated order,
   the p-type electron blocking layer formation step:
      sets the Al composition ratio y as not less than 0.35 and not more than 0.45; and
      sets a thickness of the p-type electron blocking layer as not less than 11 nm and not more than 70 nm,
   the p-type electron blocking layer formation step and the p-type cladding layer formation step set a total thickness of the p-type electron blocking layer and the p-type cladding layer as not less than 73 nm and not more than 100 nm, and
   the p-type GaN contact layer formation step sets a thickness of the p-type GaN contact layer as not less than 5 nm and not more than 15 nm.
(11) The method of producing an ultraviolet light-emitting element according to the foregoing (10), wherein
   the p-type GaN contact layer formation step:
   sets a maximum surface roughness of a surface of the p-type GaN contact layer as 9 nm or less; and
   sets an average surface roughness of the surface of the p-type GaN contact layer as 1 nm or less.
(12) The method of producing an ultraviolet light-emitting element according to the foregoing (9) or (10), further comprising a p-side electrode formation step of forming a p-side electrode on the p-type GaN contact layer.

### (Advantageous Effect)

It is possible to provide an ultraviolet light-emitting element that enables high light emission output with a central emission wavelength of more than 320 nm and less than 350 nm, and in particular more than 330 nm and less than 350 nm, and also to provide a method of producing the same.

### BRIEF DESCRIPTION OF THE DRAWINGS

In the accompanying drawings:
FIG. 1 is a diagram illustrating layer structure of an ultraviolet light-emitting element according to a present embodiment;
FIG. 2 is a diagram for describing a step of forming a substrate of an ultraviolet light-emitting element;
FIG. 3 is a diagram for describing a step of forming a layer structure of an ultraviolet light-emitting element;
FIG. 4 is a diagram for describing a step of exposing part of an n-type semiconductor layer through etching; and
FIG. 5 is a diagram with p-type cladding layer thickness on a vertical axis and p-type electron blocking layer thickness on a horizontal axis that indicates thicknesses in examples and comparative examples.

### DETAILED DESCRIPTION

The following first describes the background of development of an ultraviolet light-emitting element according to an embodiment of the present disclosure. According to the scope of knowledge in the prior art, increasing the thickness of an electron blocking layer or a cladding layer through which light passes increases light extraction and thus can be expected to improve output. However, the inventor and colleagues discovered that when the Al composition ratio and thickness of a p-type electron blocking layer are set within prescribed ranges and when the combination of thicknesses of the p-type electron blocking layer and a p-type cladding layer is set within a prescribed range, output of an ultraviolet light-emitting element improves contrary to what would be expected based on knowledge in the prior art. It was also found that by setting the thicknesses of these p-type layers within the aforementioned prescribed ranges, it becomes easier to control the thickness, variation between lots decreases, and light emission output in the plane of a wafer is stabilized and yield improves compared to with thick p-type layers. Furthermore, it was found that when the Al composition ratio and thickness of a p-type electron blocking layer are set within prescribed ranges and when the combination of thicknesses of the p-type electron blocking layer and a p-type cladding layer is set within a prescribed range, flatness of a surface of a p-type contact layer at which an electrode is formed can be ensured even with a thin p-type contact layer thickness.

The following describes an ultraviolet light-emitting element and method of producing the same according to an embodiment of the present disclosure based on the drawings.

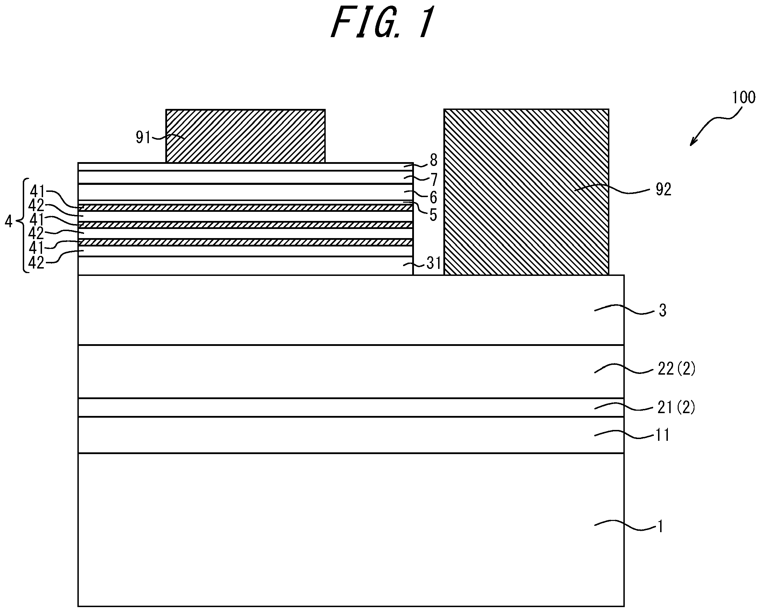

FIG. 1 illustrates an ultraviolet light-emitting element 100 according to the present embodiment (hereinafter, also referred to as a "light-emitting element 100"). The light-emitting element 100 includes, in stated order on a substrate 1, an AlN layer 11, a buffer layer 2, an n-type semiconductor layer 3 formed of AlₓGa₁₋ₓN having an Al composition ratio x, an n-type guide layer 31, a quantum well-type light-emitting layer 4 (hereinafter, also referred to as a "light-emitting layer 4"), an i-type guide layer 5, a p-type electron blocking layer 6 formed of Al_{y}Ga_{1-y}N having an Al composition ratio y, a p-type cladding layer 7 formed of Al_{z}Ga_{1-z}N having an Al composition ratio z, and a p-type GaN contact layer 8 (hereinafter, also referred to as a "contact layer 8"). Note that in order to facilitate description, the thicknesses of layers of the light-emitting element 100 illustrated in the drawing in FIG. 1 are displayed with the ratio of layer thicknesses adjusted so as to be more clearly visible in the drawing. The ratio of layer thicknesses in the drawing illustrated in FIG. 1 differs from the actual ratio of layer thicknesses in the light-emitting element 100.

In addition, the light-emitting element 100 includes a p-side electrode 91 (as a reflective electrode) on a surface of the contact layer 8 at an opposite side thereof to a surface at a side facing toward the p-type cladding layer 7 and includes an n-side electrode 92 on the same surface of the n-type semiconductor layer 3 as the light-emitting layer 4.

This light-emitting element 100 enables high light emission output with a central emission wavelength of more than 320 nm and less than 350 nm. The central emission wavelength that is suitable for the light-emitting element 100 is not less than 331 nm and not more than 349 nm.

This light-emitting element 100 can be produced, for example, by a production method described below. Specifically, one example of a method of producing the light-emitting element 100 includes: an n-type semiconductor layer formation step of forming an n-type semiconductor layer 3; a light-emitting layer formation step of forming a light-emitting layer 4; a p-type electron blocking layer formation step of forming a p-type electron blocking layer 6; a p-type cladding layer formation step of forming a p-type cladding layer 7; and a p-type GaN contact layer formation step of forming a contact layer 8.

In the method of producing the light-emitting element 100, the n-type semiconductor layer formation step, the light-emitting layer formation step, the p-type electron blocking layer formation step, the p-type cladding layer formation step, and the p-type GaN contact layer formation step are performed in stated order.

The p-type electron blocking layer formation step sets the Al composition ratio y as not less than 0.35 and not more than 0.45 and sets the thickness of the p-type electron blocking layer 6 as not less than 11 nm and not more than 70 nm, the p-type electron blocking layer formation step and the p-type cladding layer formation step set the total thickness of the p-type electron blocking layer 6 and the p-type cladding layer 7 as not less than 73 nm and not more than 100 nm, and the p-type GaN contact layer formation step sets the thickness of the contact layer 8 as not less than 5 nm and not more than 15 nm.

The following describes the light-emitting element 100 and the method of producing the same in detail.

### <Layer thickness>

In the present embodiment, the thickness of each layer of the light-emitting element 100 is measured based on an image recorded by a TEM-EDS (transmission electron microscope). In other words, the thickness of each layer is taken to be an average value for the thickness of that layer in an image recorded with respect to a cross-section of the light-emitting element 100. Note that the thickness of the substrate 1 is taken to be a value measured by an SEM (scanning electron microscope).

### <Measurement of Al composition ratio>

"AlGaN" referred to in the present embodiment indicates Al_{α}Ga_{1-α}N having an Al composition ratio α. The value of the Al composition ratio α of AlGaN in the present embodiment is determined from a wavelength observed by photoluminescence measurement performed with respect to the surface of each layer when that layer has been grown. The Al composition ratio α is within a range of not less than 0 and not more than 1 unless otherwise specified. EDS (energy dispersive X-ray spectroscopy) can be used, for example, as a method of determining the Al composition from a cross-section of the light-emitting element 100.

Moreover, "GaN" and "AlN" as used in the present embodiment respectively indicate that Ga and Al have a composition ratio of 1.0. With regards to "GaN", "AlN", and "AlGaN", it is permissible for a trace amount of another group III element that is not stipulated (inclusive of indium) to be included with a composition ratio of 0.04 or less (mole fraction of 4% or less).

### <Measurement of surface roughness>

Values for surface roughness in the present embodiment are determined by performing AFM (atomic force microscope) measurement with respect to a square area of 5 µm × 5 µm. The arithmetic average roughness (Ra) and the maximum surface roughness (Rmax) are determined in accordance with the stipulations of JIS (B0601-2001) based on a surface profile obtained through AFM measurement. The arithmetic average roughness (Ra) and the maximum surface roughness (Rmax) may be determined through automated calculation by application software accompanying the AFM apparatus.

### <Measurement of crystallinity>

In the present embodiment, a value of the full width at half maximum (arcsec) of an X-ray rocking curve obtained by an X-ray diffractometer is adopted as an evaluation of crystallinity. The full width at half maximum may be determined through automated calculation by application software accompanying the X-ray diffractometer. In the present embodiment, X-ray irradiation is performed with respect to (0001) planes and (10-12) planes of an evaluation subject, and a diffraction profile thereof is evaluated. In particular, measurement results at (10-12) planes serve as an index for threading dislocation density (screw and edge mixed dislocations) inside of crystals.

### <Measurement of dopant concentration>

Dopant concentrations in the present disclosure are taken to be values measured by SIMS (secondary ion mass spectrometry). Note that the term "undoped" means that a source gas of a prescribed dopant such as Mg or Si is not intentionally supplied during MOCVD growth, though unavoidable impurities in the production process such as C, H, and O may be included. Moreover, the term "i-type" as used in the present disclosure means undoped and having a carrier density of 4 × 10¹⁶ cm⁻³ or less.

The substrate 1 may be a commonly known substrate that enables epitaxial growth of a group III nitride. For example, a sapphire substrate, an AlN substrate, a GaN substrate, a SiC substrate, or the like can be used. In the present embodiment, a case in which the substrate 1 is a sapphire substrate is described below as an example.

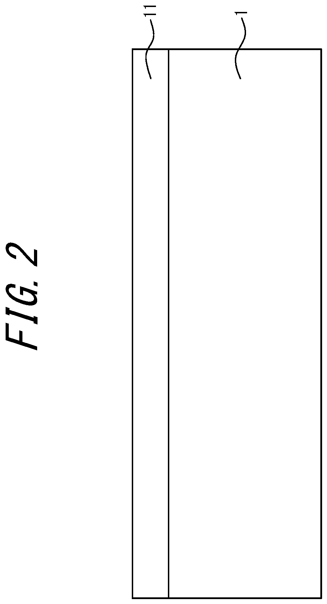

In a case in which a sapphire substrate is used as the substrate 1, it is more preferable to use an AlN template substrate that is obtained by forming an AlN layer 11 on the substrate 1 as illustrated in FIG. 2, and subjecting this AlN layer 11 to heat treatment at high temperature to diminish dislocations until the full width at half maximum of an X-ray rocking curve for (10-12) planes of the AlN layer 11 is 400 seconds or less. In the following description, a substrate obtained by forming the AlN layer 11 on the substrate 1 is referred to as an AlN template substrate.

### <Buffer layer>

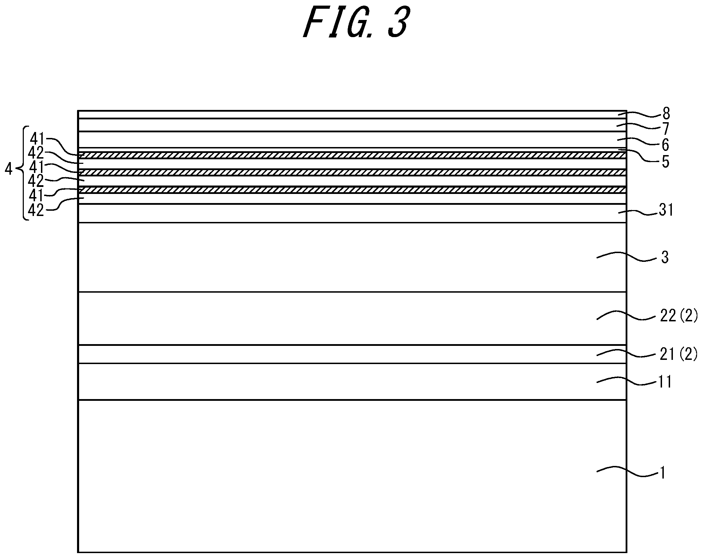

Next, the buffer layer 2 is formed on the AlN template substrate as illustrated in FIG. 1 and FIG. 3. The buffer layer 2 is a layer that is located between the AlN layer 11 on the substrate 1 and the n-type semiconductor layer 3 and that eases lattice constant mismatch of the substrate 1 and the AlN layer 11 with the n-type semiconductor layer 3. The buffer layer 2 is preferably configured as a layer resulting from stacking of a plurality of AlGaN layers of differing Al composition or as a layer having an Al composition gradient. Moreover, the buffer layer 2 is preferably undoped. The thickness of the buffer layer 2 is preferably not less than 500 nm and not more than 2,000 nm, for example.

FIG. 1 and FIG. 3 illustrate a case in which the buffer layer 2 is a layer resulting from stacking of a first buffer layer 21 and a second buffer layer 22 that are AlGaN layers of differing Al composition.

### <n-Type semiconductor layer>

The n-type semiconductor layer 3 is a layer that contains an n-type dopant such as Si in AlₓGa₁₋ₓN having an Al composition ratio x and that functions as an n-type semiconductor. The concentration of the n-type dopant is preferably approximately 1 × 10¹⁸ cm⁻³ to 5 × 10¹⁹ cm⁻³. The n-type semiconductor layer 3 is formed after formation of the buffer layer 2 and is formed at an opposite surface side of the buffer layer 2 to a surface at a side facing toward the AlN template substrate (one example of an n-type semiconductor layer formation step).

The average surface roughness (Ra) of a 5 µm-square area of the surface of the n-type semiconductor layer 3 is preferably 1 nm or less. Through the n-type semiconductor layer 3 having a flat surface, it is possible to also maintain the flatness of a layer that is grown thereon.

Moreover, the full width at half maximum for (10-12) planes of the n-type semiconductor layer 3 according to X-ray diffraction is preferably 350 seconds or less, and more preferably 300 seconds or less. The Al composition ratio x of the n-type semiconductor layer 3 is preferably not less than 0.2 and not more than 0.35. The Al composition ratio x is larger than the Al composition ratio w of the subsequently described well layers 41 (w < x).

The thickness of the n-type semiconductor layer 3 should be sufficiently thick for supplying carriers and is preferably not less than 300 nm and not more than 3,000 nm, for example.

The n-side electrode 92 is formed on part of the exposed n-type semiconductor layer 3 as described further below. As a modified example, an AlGaN layer having an Al composition of not less than 0 and not more than 0.2 that is lower than the Al composition of the n-type semiconductor layer 3 may be included between the n-type semiconductor layer 3 and the n-side electrode 92.

An n-type guide layer 31 that is a layer functioning as an n-type semiconductor that contains an n-type dopant such as Si in AlGaN having the same Al composition ratio as the n-type semiconductor layer 3 and that is thinner than the n-type semiconductor layer 3 may be formed on the n-type semiconductor layer 3.

### <Light-emitting layer>

The light-emitting layer 4 is a layer that includes layers formed of AlGaN. The light-emitting layer 4 includes a plurality of well layers 41 and a plurality of barrier layers 42 and is a layer resulting from alternate stacking of these layers. In other words, the light-emitting layer 4 includes well layers 41 having an Al composition ratio in accordance with the central emission wavelength and barrier layers 42 that sandwich the well layers 41 and has a configuration in which a combination of a well layer 41 and a barrier layer 42 is repeated for one or more pairs. Both surfaces of the light-emitting layer 4 are constituted by barrier layers 42. The light-emitting layer 4 is formed after formation of the n-type semiconductor layer 3 and is formed at an opposite surface side of the n-type semiconductor layer 3 to a surface at a side facing toward the AlN template substrate (one example of a light-emitting layer formation step).

The well layers 41 in the present embodiment are layers formed of Al_{w}Ga_{1-w}N having an Al composition ratio w. The Al composition ratio w is preferably set as w < 0.3 in a case in which the central emission wavelength is to be set as more than 320 nm, for example. Moreover, the Al composition ratio w is preferably set as w ≤ 0.15 in a case in which the central emission wavelength is to be set as 331 nm or more. Furthermore, the Al composition ratio w is preferably set as 0.07 ≤ w in a case in which the central emission wavelength is to be set as 349 nm or less. The thickness of the well layers 41 is preferably set as not less than 1 nm and not more than 5 nm. The well layers 41 are preferably undoped.

The barrier layers 42 are layers formed of Al_{b}Ga_{1-b}N having an Al composition ratio b. The Al composition ratio b of the barrier layers 42 is preferably set within a range of w + 0.05 ≤ b ≤ w + 0.3. The thickness of the barrier layers 42 is preferably set as not less than 3 nm and not more than 20 nm. The barrier layers 42 may be undoped or may be n-type layers that are doped with an n-type dopant such as Si.

### <i-Type guide layer>

The i-type guide layer 5 is an i-type layer having a higher Al composition ratio than the barrier layers 42 and having a thickness of not less than 0.7 nm and not more than 1.3 nm. The Al composition ratio of the i-type guide layer 5 is preferably higher than the Al composition ratio y of the subsequently described p-type electron blocking layer 6, with AlN being most preferable. The i-type guide layer 5 is formed after formation of the light-emitting layer 4 and is formed at an opposite surface side of the light-emitting layer 4 to a surface at a side facing toward the AlN template substrate (one example of a light-emitting layer formation step).

There are two types of methods by which the i-type guide layer 5 may be produced. One method involves directly forming an i-type guide layer 5 that has the thickness and Al composition described above. Another method involves forming an AlGaN layer having a thickness not less than the thickness described above, and subsequently causing the Al composition to rise through volatilization of Ga in the AlGaN layer due to reduction of nitrogen partial pressure when the carrier gas is changed from nitrogen to hydrogen, thereby resulting in an i-type guide layer 5 that has the thickness and Al composition described above. In the present embodiment, either of these methods can be adopted.

### <p-Type electron blocking layer>

The p-type electron blocking layer 6 is a layer that is formed of Al_{y}Ga_{1-y}N having an Al composition ratio y and that functions as a p-type semiconductor. A p-type dopant (p-type impurity) with which the p-type electron blocking layer 6 is doped may be Mg, for example. The concentration of the p-type dopant may be approximately 1 × 10¹⁸ cm⁻³ to 5 × 10¹⁹ cm⁻³. The p-type electron blocking layer 6 is formed after formation of the i-type guide layer 5 and is formed at an opposite surface side of the i-type guide layer 5 to a surface at a side facing toward the AlN template substrate.

The Al composition ratio y is not less than 0.35 and not more than 0.45. The thickness of the p-type electron blocking layer 6 is not less than 11 nm and not more than 70 nm. As a result of the p-type electron blocking layer 6 having an Al composition ratio y and a thickness such as set forth above, deterioration of surface roughness of the p-type electron blocking layer 6 can be inhibited while also enabling the p-type electron blocking layer 6 to fulfill its role as an electron blocking layer and improve light emission output. It is even more preferable that the thickness is set as 60 nm or less for improving light emission output.

In a case in which the Al composition ratio y exceeds 0.45 or a case in which the thickness of the p-type electron blocking layer 6 exceeds 70 nm, surface roughness (particularly maximum surface roughness) of the p-type electron blocking layer 6 and the contact layer 8 may significantly increase. In a case in which the Al composition ratio y is less than 0.35 or a case in which the thickness of the p-type electron blocking layer 6 is not more than 10 nm or exceeds 70 nm, deterioration of reliability or reduction of light emission output may arise.

The p-type electron blocking layer 6 may be configured as a single layer or may be configured as a plurality of layers. In a case in which the p-type electron blocking layer 6 is configured as a plurality of layers, the p-type electron blocking layer 6 may include layers of differing Al composition, may include layers of differing dopant concentration, or may include a Si-doped layer or a layer co-doped with Si and Mg.

### <p-Type cladding layer>

The p-type cladding layer 7 is a layer that is formed of Al_{z}Ga_{1-z}N having an Al composition ratio z and that functions as a p-type semiconductor. The Al composition ratio z is preferably not less than 0.17 and not more than 0.27. A p-type dopant with which the p-type cladding layer 7 is doped may be Mg, for example. The concentration of the p-type dopant may be approximately 1 × 10¹⁸ cm⁻³ to 5 × 10¹⁹ cm⁻³. The p-type cladding layer 7 is formed after formation of the p-type electron blocking layer 6 and is formed at an opposite surface side of the p-type electron blocking layer 6 to a surface at a side facing toward the AlN template substrate (one example of a p-type cladding layer formation step).

In terms of the relationship of the Al composition ratio z of the p-type cladding layer 7 with the Al composition ratios of other layers, the Al composition ratio z of the p-type cladding layer 7 is less than the Al composition ratio y of the p-type electron blocking layer 6 (z < y). The Al composition ratio z of the p-type cladding layer 7 is preferably set as not less than 0.48 times and not more than 0.60 times the Al composition ratio y of the p-type electron blocking layer 6. In the following description, a ratio of the Al composition ratio z of the p-type cladding layer 7 relative to the Al composition ratio y of the p-type electron blocking layer 6 may also be referred to as an "Al ratio". Moreover, the Al composition ratio z is also preferably not more than the Al composition ratio x of the n-type semiconductor layer 3 (z ≤ x). The Al composition ratio z is larger than the Al composition ratio w of the previously described well layers 41 (w < z).

The thickness of the p-type cladding layer 7 is preferably adjusted according to the thickness of the p-type electron blocking layer 6 as follows.

When determining the thickness of the p-type cladding layer 7, the total thickness of the p-type electron blocking layer 6 and the p-type cladding layer 7 is set as not less than 73 nm and not more than 100 nm. By keeping the total thickness within this range, it is possible to achieve a balance of light emission output and flatness. Setting the total thickness of the p-type electron blocking layer 6 and the p-type cladding layer 7 as 79 nm or more is more preferable for improving light emission output.

Moreover, with an electron blocking layer thickness of 60 nm or less, increasing the total thickness while keeping a fixed electron blocking layer thickness tends to increase output, and thus setting the electron blocking layer thickness as not less than 11 nm and not more than 60 nm and the total thickness of the p-type electron blocking layer 6 and the p-type cladding layer 7 as not less than 79 nm and less than 100 nm is more preferable as ranges yielding a more remarkable output improvement effect.

A value obtained by dividing the thickness of the p-type cladding layer 7 by the thickness of the p-type electron blocking layer 6 (hereinafter, also referred to as a "layer thickness ratio") should at least be 0.1 or more. In order to restrict the maximum surface roughness (Rmax) of the contact layer 8, the layer thickness ratio is preferably 0.4 or more, and more preferably 0.55 or more. The upper limit for the layer thickness ratio can be set as 6.0 or less. When the layer thickness ratio is less than 0.4, surface flatness of the p-type cladding layer 7 tends to deteriorate, and Rmax of the contact layer 8 tends to increase.

### <Contact layer>

The contact layer 8 is a layer that is formed of GaN and that functions as a p-type semiconductor. A p-type dopant with which the contact layer 8 is doped may be Mg, for example. The concentration of the p-type dopant may be approximately 1 × 10¹⁹ cm⁻³ to 5 × 10²¹ cm⁻³. The contact layer 8 is formed after formation of the p-type cladding layer 7 and is formed at an opposite surface side of the p-type cladding layer 7 to a surface at a side facing toward the AlN template substrate (one example of a p-type GaN contact layer formation step).

The thickness of the contact layer 8 is not less than 5 nm and not more than 15 nm. The thickness of the contact layer 8 is more preferably not less than 5 nm and not more than 10 nm. By setting the p-type electron blocking layer 6 and the p-type cladding layer 7 as described above, the contact layer 8 can be provided with a flat surface even when the contact layer 8 is a thin layer in this manner.

The maximum surface roughness (Rmax) of a square area of 5 µm × 5 µm at the surface of the contact layer 8 is 9 nm or less, preferably 8 nm or less, and more preferably less than 6.5 nm. The maximum surface roughness at the surface of the contact layer 8 can be set as 8 nm or less by setting the range for the Al composition ratio of the p-type electron blocking layer 6 as not less than 0.35 and not more than 0.45 and setting the above-described layer thickness ratio as 0.4 or more. Moreover, the maximum surface roughness at the surface of the contact layer 8 can be set as less than 6.5 nm by setting the range for the Al composition ratio of the p-type electron blocking layer 6 as not less than 0.35 and not more than 0.45 and setting the above-described layer thickness ratio as 0.55 or more. In a case in which the maximum surface roughness (Rmax) is large, the formation of a p-side electrode 91 at the surface having this maximum surface roughness may result in loss of reliability of the p-side electrode 91. As a consequence thereof, the p-side electrode 91 may be broken and the light-emitting element 100 may suddenly cease light emission when current is passed through the light-emitting element 100.

The average surface roughness (Ra) of a square area of 5 µm × 5 µm at the surface of the contact layer 8 is preferably 1 nm or less, and more preferably not less than 0.01 nm and not more than 0.6 nm.

The contact layer 8 may be configured as a single layer or may be configured as a plurality of layers. In a case in which the contact layer 8 is configured as a plurality of layers, the contact layer 8 may include layers of differing Al composition, may include layers of differing dopant concentration, or may include a Si-doped layer or a layer co-doped with Si and Mg. The contact layer 8 may preferably include a region having a high p-type dopant concentration of approximately 1 × 10²⁰ cm⁻³ to 5 × 10²¹ cm⁻³ at the outermost surface at a side where the p-side electrode 91 is formed.

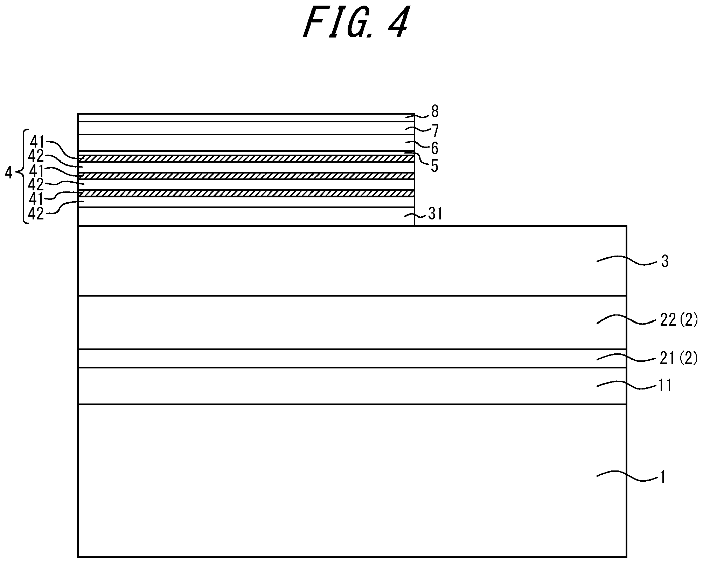

In a case in which the light-emitting element 100 is to be a flip chip-type element, dry etching is performed to remove part of the n-type guide layer 31 and the light-emitting layer 4 through to the contact layer 8, which are disposed above the n-type semiconductor layer 3, thereby exposing part of the n-type semiconductor layer 3 as illustrated in FIG. 4, and then the n-side electrode 92 is formed on part of the n-type semiconductor layer 3 that has been exposed (on the surface at the same side as the light-emitting layer 4 in the present embodiment) as illustrated in FIG. 1. Moreover, the p-side electrode 91 is formed on part of the contact layer 8 (on a surface at an opposite side of the contact layer 8 to a surface at a side facing toward the AlN template substrate) (one example of a p-side electrode formation step). Note that as a modified example, after part of the n-type semiconductor layer 3 is exposed, a layer formed of AlGaN having an Al composition ratio of not less than 0 and not more than 0.2 that is lower than the Al composition ratio of the n-type semiconductor layer 3 may be formed on the exposed n-type semiconductor layer 3, and the n-side electrode 92 may then be formed on that layer.

A commonly known electrode that can be used for the contact layer 8 may be selected as the p-side electrode 91. The p-side electrode 91 is preferably a reflective electrode having a reflectance of 50% or more at the central emission wavelength. For example, a combination of a first metal (Ni) and a second metal (Au, Rh) or a conductive metal nitride can be used as the p-side electrode 91. In a case in which the p-side electrode 91 is to be a reflective electrode, it is preferable that Rh is contained in the p-side electrode 91.

A commonly known electrode that can be used for the contact layer 8 may be selected as the n-side electrode 92. For example, a combination of a first metal (Ti) and a second metal (Al, Rh) or a conductive metal nitride can be used as the n-side electrode 92.

When performing singulation of chips of individual light-emitting elements 100 from a wafer, layers on the substrate at a planned separation position are preferably removed by dry etching or the like. During this removal, a mesa (inclined portion) may arise at a side surface of each layer. The chip size of the light-emitting element 100 can be set as a square, rectangular, or hexagonal shape having a side length of 200 µm to 2,000 µm. Singulation of the substrate can be performed by scribing or laser dicing. The thickness of the substrate may be adjusted through grinding or the like prior to division.

In another embodiment, the light-emitting element 100 may be a vertical-type element. A vertical-type element can be obtained by a method in which a conductive substrate is used as a substrate for epitaxial growth or a method in which a substrate that has been used in epitaxial growth is removed. In a case in which a substrate that has been used in epitaxial growth is removed, the p-side electrode 91 is formed on the contact layer 8, a conductive support having sufficient thickness such that the light-emitting element 100 has thickness enabling handling is formed thereon, and then the substrate for growth (sapphire substrate) is removed by a commonly known method, and the n-side electrode 92 is formed on part of the exposed n-type semiconductor layer 3.

MOCVD can be adopted as the method of epitaxial growth of each layer. In epitaxial growth of each layer, it is preferable to use a source gas including trimethylaluminum gas (TMA gas), trimethylgallium gas (TMG) gas, and ammonia gas (NH₃ gas). The growth temperature during epitaxial growth is dependent on the Al composition ratio but is preferably not lower than 1000°C and not higher than 1400°C. Moreover, the growth pressure inside of a chamber where epitaxial growth is performed can be set as 10 Torr to 760 Torr, for example. Note that the flow rate of the source gas is preferably set as appropriate in accordance with the growth temperature and the growth pressure so as to obtain an optimal mole ratio of group V element relative to group III element (V/III ratio).

The following describes the light-emitting element 100 according to the present embodiment through examples.

### (Example 1)

A sapphire substrate (diameter: 2 inches; thickness: 430 µm; orientation (0001); m-axis direction off-angle θ: 0.5°) was prepared, and an AlN layer having a central thickness of 600 nm was grown on this sapphire substrate by MOCVD. Thereafter, 4 hours of heat treatment was performed in a nitrogen gas atmosphere at 1650°C using a heat treatment furnace so as to obtain an AlN template substrate.

The AlN layer of the AlN template substrate had a full width at half maximum of 288 seconds (i.e., 300 seconds or less) for a (10-12) X-ray rocking curve determined by an X-ray diffractometer (D8 DISCOVER AUTOWAFS; produced by Bruker AXS; Cu Kα1 line).

An AFM (atomic force microscope) was used to measure the surface roughness of the AlN template substrate in a square area of 5 µm × 5 µm at a central part of the wafer. The average surface roughness (Ra) was determined to be 0.23 nm and the maximum surface roughness (Rmax) was determined to be 3 nm through this measurement.

After the AlN template substrate had been obtained, a first buffer layer of 30 nm in thickness that was formed of undoped Al_{0.4}Ga_{0.6}N and then a second buffer layer of 1,000 nm in thickness that was formed of undoped Al_{0.25}Ga_{0.75}N were formed on the AlN template substrate by MOCVD.

Next, an n-type semiconductor layer of 2,400 nm in thickness that was doped with Si was formed on the second buffer layer. When the crystallinity of the n-type semiconductor layer was measured by X-ray diffraction in the same manner as described above after withdrawal thereof from the MOCVD furnace at this point, the full width at half maximum of a (10-12) plane X-ray rocking curve was 270 seconds (i.e., 300 seconds or less).

An AFM was used to measure the surface roughness of the n-type semiconductor layer in a square area of 5 µm × 5 µm at a central part of the wafer. The average surface roughness (Ra) was determined to be 0.5 nm and the maximum surface roughness (Rmax) was determined to be 7.4 nm through this measurement. The Si concentration of the n-type semiconductor layer was determined to be 1.0 × 10¹⁹ atoms/cm³ as a result of SIMS analysis.

Next, the growth temperature was changed from 1200°C to 1100°C, and then an n-type guide layer of 25 nm in thickness that was formed of Si-doped Al_{0.25}Ga_{0.75}N was formed on the n-type semiconductor layer. Thereafter, formation of a barrier layer of 12 nm in thickness that was formed of Si-doped Al_{0.25}Ga_{0.75}N and a well layer of 2.4 nm in thickness that was formed of undoped Al_{0.10}Ga_{0.90}N was repeated three times to obtain a quantum well structure as a light-emitting layer.

Subsequently, an i-type guide layer of 3 nm in thickness that was formed of undoped Al_{0.25}Ga_{0.75}N was formed on the light-emitting layer (on the third well layer). Thereafter, supply of group III source gas was suspended while continuing supply of group V source gas, nitrogen gas as a carrier gas was suspended and the carrier gas was changed to hydrogen gas, and supply of group III source gas was initiated 1 minute from the start of supply of hydrogen gas so as to form a p-type electron blocking layer of 54 nm in thickness that was formed of Mg-doped Al_{0.4}Ga_{0.6}N, form a p-type cladding layer of 29 nm in thickness that was formed of Mg-doped Al_{0.22}Ga_{0.78}N, and form a p-type contact layer (p-type GaN contact layer) of 8 nm in thickness that was formed of Mg-doped GaN. In accompaniment to the change of carrier gas described above, the i-type guide layer changed to an i-type guide layer having an Al composition ratio of roughly 1 and a thickness of 1.0 nm through Ga component volatilization and decomposition.

An AFM was used to measure the surface roughness of the p-type contact layer in a square area of 5 µm × 5 µm at a central part of the wafer straight after epitaxial formation. The average surface roughness (Ra) of the p-type contact layer was determined to be 0.39 nm and the maximum surface roughness (Rmax) of the p-type contact layer was determined to be 7.4 nm through this measurement. The Mg concentrations of the p-type electron blocking layer, the p-type cladding layer, and the p-type contact layer were determined to be 1.0 × 10¹⁹ atoms/cm³, 5.0 × 10¹⁹ atoms/cm³, and 2.0 × 10²⁰ atoms/cm³, respectively, as a result of SIMS analysis.

The Al composition ratio, type of dopant, and thickness of each layer in Example 1 are shown in Table 1. Measurement values for thicknesses recorded in Table 1 are recorded based on measurement results obtained using a TEM. The Al composition of each layer was determined from a wavelength observed by photoluminescence measurement.

**[Table 1]**

| | Al composition ratio | Dopant | Thickness |
|---|---|---|---|
| p-Type contact layer | 0 | Mg | 8 nm |
| p-Type cladding layer | 0.22 | Mg | 29 nm |
| p-Type electron blocking layer | 0.4 | Mg | 54 nm |
| i-Type guide layer | 1 | - | 1.0 nm |
| Well layer | 0.1 | - | 2.4 nm |
| Barrier layer | 0.25 | Si | 12 nm |
| Well layer | 0.1 | - | 2.4 nm |
| Barrier layer | 0.25 | Si | 12 nm |
| Well layer | 0.1 | - | 2.4 nm |
| Barrier layer | 0.25 | Si | 12 nm |
| n-Type guide layer | 0.25 | Si | 25 nm |
| n-Type semiconductor layer | 0.25 | Si | 2400 nm |
| Second buffer layer | 0.25 | - | 1000 nm |
| First buffer layer | 0.4 | - | 35 nm |
| AlN layer | 1 | - | 600 nm |
| Sapphire substrate | - | - | 430 µm |

In addition, a mask was formed on the p-type contact layer, and mesa etching was performed by dry etching so as to expose part of the n-type semiconductor layer. The mask on the p-type contact layer was subsequently removed.

Next, a Ni layer of 7 nm in thickness and a Rh layer of 50 nm in thickness were formed on the p-type contact layer so as to obtain a p-side electrode as a reflective electrode.

Moreover, a Ti layer of 20 nm in thickness and an Al layer of 150 nm in thickness were formed on the exposed part of the n-type semiconductor layer so as to obtain an n-side electrode.

Stacking of the p-side electrode and the n-side electrode was performed by sputtering. Formation of an electrode pattern of the p-side electrode and the n-side electrode was performed by a lift-off method using a resist.

Furthermore, an infrared lamp annealing heater was used to perform 10 minutes of contact annealing at 550°C, and then a laser scriber was used to separate individual elements with a square 1,000 µm × 1,000 µm chip size so as to produce an ultraviolet light-emitting element (hereinafter, referred to simply as a "light-emitting element") according to Example 1. The thickness of the sapphire substrate after separation was 430 µm.

### (Examples 2 to 16, Comparative Examples 1 to 6, and conventional example).

Light-emitting elements according to Examples 2 to 16, Comparative Examples 1 to 6, and a conventional example were produced in the same way as in Example 1 with the exception that the Al composition ratios and layer thicknesses of the p-type electron blocking layer and the p-type cladding layer in Example 1 were changed as shown in Table 2 and Table 3.

Specifically, Example 2 is the same as Example 1 with the exception that the thickness of the p-type cladding layer was set as 35 nm. Example 3 is the same as Example 1 with the exception that the thickness of the p-type cladding layer was set as 41 nm. Example 4 is the same as Example 1 with the exception that the thickness of the p-type blocking layer was set as 22 nm and the thickness of the p-type cladding layer was set as 64 nm. Example 5 is the same as Example 1 with the exception that the thickness of the p-type blocking layer was set as 38 nm and the thickness of the p-type cladding layer was set as 41 nm. Example 6 is the same as Example 1 with the exception that the thickness of the p-type blocking layer was set as 38 nm and the thickness of the p-type cladding layer was set as 35 nm. Example 7 is the same as Example 1 with the exception that the thickness of the p-type blocking layer was set as 11 nm and the thickness of the p-type cladding layer was set as 64 nm. Example 8 is the same as Example 1 with the exception that the thickness of the p-type blocking layer was set as 54 nm and the thickness of the p-type cladding layer was set as 23 nm. Example 9 is the same as Example 1 with the exception that the thickness of the p-type blocking layer was set as 70 nm and the thickness of the p-type cladding layer was set as 29 nm. Example 10 is the same as Example 1 with the exception that the thickness of the p-type blocking layer was set as 70 nm and the thickness of the p-type cladding layer was set as 12 nm.

Example 11 is the same as Example 1 with the exception that the thickness of the p-type blocking layer was set as 11 nm and the thickness of the p-type cladding layer was set as 76 nm. Example 12 is the same as Example 1 with the exception that the thickness of the p-type blocking layer was set as 11 nm and the thickness of the p-type cladding layer was set as 70 nm. Example 13 is the same as Example 1 with the exception that the thickness of the p-type blocking layer was set as 11 nm and the thickness of the p-type cladding layer was set as 89 nm. Example 14 is the same as Example 1 with the exception that the thickness of the p-type blocking layer was set as 22 nm and the thickness of the p-type cladding layer was set as 78 nm. Example 15 is the same as Example 1 with the exception that the thickness of the p-type blocking layer was set as 38 nm and the thickness of the p-type cladding layer was set as 62 nm. Example 16 is the same as Example 1 with the exception that the thickness of the p-type blocking layer was set as 70 nm and the thickness of the p-type cladding layer was set as 3 nm.

Comparative Example 1 is the same as Example 1 with the exception that the thickness of the p-type cladding layer was set as 18 nm. Comparative Example 2 is the same as Example 1 with the exception that the thickness of the p-type blocking layer was set as 38 nm and the thickness of the p-type cladding layer was set as 29 nm. Comparative Example 3 is the same as Example 1 with the exception that the thickness of the p-type blocking layer was set as 86 nm and the thickness of the p-type cladding layer was set as 29 nm. Comparative Example 4 is the same as Example 1 with the exception that the thickness of the p-type blocking layer was set as 22 nm and the thickness of the p-type cladding layer was set as 41 nm. Comparative Example 5 is the same as Example 1 with the exception that the thickness of the p-type blocking layer was set as 11 nm and the thickness of the p-type cladding layer was set as 53 nm. Comparative Example 6 is the same as Example 1 with the exception that the thickness of the p-type blocking layer was set as 5 nm and the thickness of the p-type cladding layer was set as 64 nm. The conventional example is the same as Example 1 with the exception that the thickness of the p-type cladding layer was set as 350 nm.

Note that "BL" and "CL" in Table 2 and Table 3 are abbreviations that respectively indicate the p-type electron blocking layer and the p-type cladding layer. Moreover, "Al ratio" is a ratio of the Al composition ratio of the cladding layer relative to the Al composition ratio of the p-type electron blocking layer. Furthermore, "Thickness ratio CL/BL" is a value obtained by dividing the thickness of the p-type cladding layer by the thickness of the p-type electron blocking layer. Also, "Total thickness BL + CL" is the total thickness of the p-type electron blocking layer and the p-type cladding layer. Note that in each of the light-emitting elements of the conventional example and the comparative examples, the thicknesses of the p-type electron blocking layer and the p-type cladding layer are set such that the total thickness of the p-type electron blocking layer and the p-type cladding layer is outside of a range of not less than 73 nm and not more than 100 nm. In the following description, the light-emitting element serving as a conventional example is a case in which the total thickness of the p-type electron blocking layer and the p-type cladding layer is extremely large that is merely referred to as a conventional example to facilitate description, and this light-emitting element also constitutes a comparative example relative to the examples according to the present embodiment.

**[Table 2]**

| | p-Type electron blocking layer | | p-Type cladding layer | | Al ratio z/y | Layer thickness ratio CL/BL | Total thickness BL + CL [nm] | Chip measurement | Contact layer AFM | |
|---|---|---|---|---|---|---|---|---|---|---|
| | BL Al composition ratio y | BL thickness [nm] | CL Al composition ratio z | CL thickness [nm] | | | | Po average [mW] | Ra [nm] | Rmax [nm] |
| Conventional example | 0.4 | 54 | 0.22 | 350 | 0.55 | 6.48 | 404 | 85.0 | 0.31 | 6.57 |
| Example 1 | 0.4 | 54 | 0.22 | 29 | 0.55 | 0.54 | 83 | 104.6 | 0.39 | 7.40 |
| Example 2 | 0.4 | 54 | 0.22 | 35 | 0.55 | 0.65 | 89 | 126.5 | 0.40 | 4.80 |
| Example 3 | 0.4 | 54 | 0.22 | 41 | 0.55 | 0.76 | 95 | 129.2 | 0.40 | 4.00 |
| Example 4 | 0.4 | 22 | 0.22 | 64 | 0.55 | 2.91 | 86 | 140.0 | 0.50 | 5.80 |
| Example 5 | 0.4 | 38 | 0.22 | 41 | 0.55 | 1.08 | 79 | 113.1 | 0.60 | 4.80 |
| Example 6 | 0.4 | 38 | 0.22 | 35 | 0.55 | 0.92 | 73 | 100.0 | 0.50 | 5.00 |
| Example 7 | 0.4 | 11 | 0.22 | 64 | 0.55 | 5.82 | 75 | 90.0 | 0.27 | 2.88 |
| Example 8 | 0.4 | 54 | 0.22 | 23 | 0.55 | 0.43 | 77 | 97.8 | 0.92 | 7.56 |
| Example 9 | 0.4 | 70 | 0.22 | 29 | 0.55 | 0.41 | 99 | 89.8 | 0.60 | 6.50 |
| Example 10 | 0.4 | 70 | 0.22 | 12 | 0.55 | 0.17 | 82 | 106.5 | 0.50 | 8.70 |
| Comparative Example 1 | 0.4 | 54 | 0.22 | 18 | 0.55 | 0.33 | 72 | 70.6 | 1.20 | 9.90 |
| Comparative Example 2 | 0.4 | 38 | 0.22 | 29 | 0.55 | 0.76 | 67 | 73.3 | 0.25 | 3.25 |
| Comparative Example 3 | 0.4 | 86 | 0.22 | 29 | 0.55 | 0.34 | 115 | 65.0 | 0.77 | 9.71 |
| Comparative Example 4 | 0.4 | 22 | 0.22 | 41 | 0.55 | 1.86 | 63 | 65.4 | 0.35 | 4.00 |
| Comparative Example 5 | 0.4 | 11 | 0.22 | 53 | 0.55 | 4.77 | 64 | 65.3 | 0.41 | 4.42 |

**[Table 3]**

| | p-Type electron blocking layer | | p-Type cladding layer | | Al ratio z/y | Layer thickness ratio CL/BL | Total thickness BL + CL [nm] | Chip measurement |
|---|---|---|---|---|---|---|---|---|
| | BL Al composition ratio y | BL thickness [nm] | CL Al composition ratio z | CL thickness [nm] | | | | Po average [mW] |
| Example 11 | 0.4 | 11 | 0.22 | 76 | 0.55 | 6.91 | 87 | 163.9 |
| Example 12 | 0.4 | 11 | 0.22 | 70 | 0.55 | 6.36 | 81 | 134.5 |
| Example 13 | 0.4 | 11 | 0.22 | 89 | 0.55 | 8.06 | 100 | 118.0 |
| Example 14 | 0.4 | 22 | 0.22 | 78 | 0.55 | 3.59 | 99 | 99.0 |
| Example 15 | 0.4 | 38 | 0.22 | 62 | 0.55 | 1.64 | 100 | 96.0 |
| Example 16 | 0.4 | 70 | 0.22 | 3 | 0.55 | 0.04 | 73 | 88.0 |
| Comparative Example 6 | 0.4 | 5 | 0.22 | 64 | 0.55 | 12.80 | 69 | 98.3* |

| | | | | | | | | |
|---|---|---|---|---|---|---|---|---|
| * Deterioration of reliability | | | | | | | | |

The light-emitting element of each example, comparative example, or conventional example was mounted on a submount made of AlN (size: 2 mm × 2 mm; thickness: 0.2 mm) by a flip chip method using spherical Au bumps. In a state with a heat sink made of Al connected to the AlN submount, 350 mA current was passed using a constant current power supply, during which, the forward voltage (Vf) was measured and the light emission output (Po) of total luminous flux was measured by an integrating sphere disposed at the sapphire substrate side.

In particular, sampling measurement was performed for the light emission output (Po) by sampling and measuring five light-emitting elements in a central portion of a wafer of each example, comparative example, or conventional example, and an average value of the measured values was calculated. These measurement results are shown as "Po average" of "Chip measurement" in Table 2 and Table 3. Note that measurement results for Examples 1 to 10, Comparative Examples 1 to 5, and the conventional example are shown in Table 2, whereas measurement results for Examples 11 to 16 and Comparative Example 6 are shown in Table 3.

An AFM was used to measure the surface roughness (Ra and Rmax) of the surface of the p-type contact layer at a central part of the wafer straight after epitaxial formation in each of Examples 1 to 10, Comparative Examples 1 to 5, and the conventional example. Results of these measurements are recorded in the items below "Contact layer AFM" in Table 2. Note that measurement of surface roughness using an AFM was not performed in Examples 11 to 16 and Comparative Example 6.

Upon measurement of the central emission wavelength (λp) for chips of the examples, comparative examples, and conventional example, the central emission wavelength of each chip was within a range of 340 nm + 5 nm.

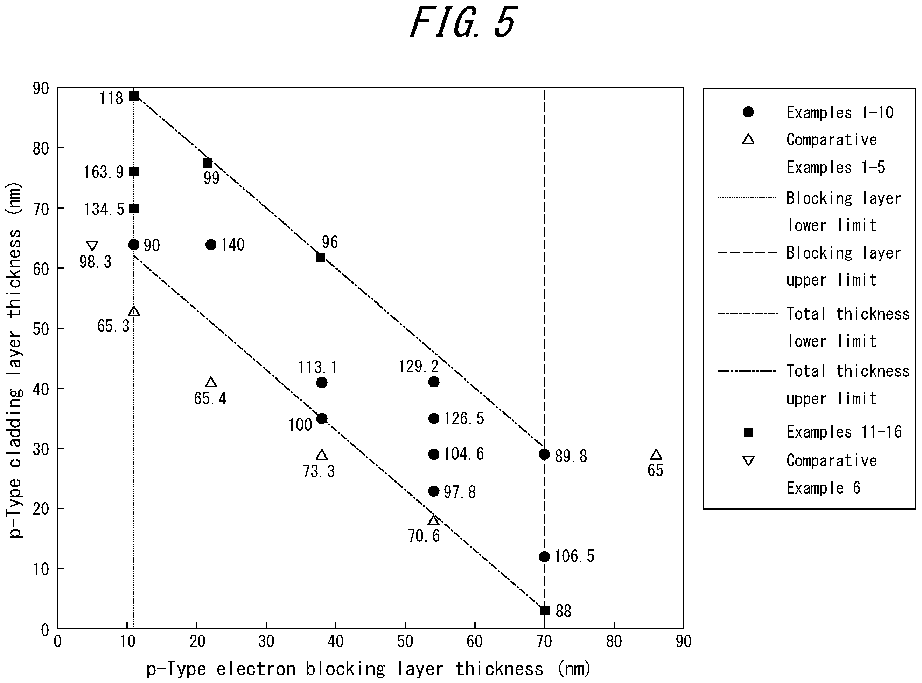

Moreover, the light-emitting elements of the examples each had a high average light emission output compared to the light-emitting elements of the conventional example and the comparative examples. In other words, a light-emitting element in which the thickness of a p-type electron blocking layer is not less than 11 nm and not more than 70 nm and in which the total thickness of the p-type AlGaN electron blocking layer and a p-type AlGaN cladding layer is not less than 73 nm and not more than 100 nm such as in the present embodiment has high light emission output compared to a light-emitting element in which this is not the case. FIG. 5 illustrates the examples and comparative examples with p-type cladding layer thickness on a vertical axis and p-type electron blocking layer thickness on a horizontal axis. Values in the drawing are values for Po average (mW). Note that although Comparative Example 6 has high initial light emission output compared to Example 7 due to the thinness of the p-type electron blocking layer, the reduction ratio of light emission output caused by passing current at 600 mA for 500 hours is 80% or less, and reliability is reduced compared to the examples. This is also indicated by "Deterioration of reliability" in Table 2.

As set forth above, the present embodiment makes it possible to provide an ultraviolet light-emitting element that enables high light emission output with a central emission wavelength of more than 320 nm and less than 350 nm, and particularly more than 330 nm and less than 350 nm.

Note that upon comparison of the examples with one another, the average surface roughness (Ra) of the p-type contact layer is preferably 1 nm or less, and more preferably not less than 0.01 nm and not more than 0.6 nm. The average surface roughness (Ra) is even more preferably not less than 0.3 nm and not more than 0.6 nm. Moreover, it seems to be preferable for the maximum surface roughness (Rmax) of the p-type contact layer to be 8 nm or less.

In this manner, it is possible to provide an ultraviolet light-emitting element that enables high light emission output with a central emission wavelength of more than 320 nm and less than 350 nm and a method of producing the same.

For the conventional example and Example 1, a chip sorting machine was used to perform measurement for a chip produced from all light-emitting elements obtained in a wafer (i.e., to perform full measurement). This full measurement was performed for 20 lots. With regards to the average and variation between lots in the results of this full measurement implemented for 20 lots, Example 1 had an average output of 89.1 mW and a standard deviation of 12.2 mW, whereas the conventional example had an average output of 77.9 mW and a standard deviation of 16.0 mW. It can be seen that the light-emitting element of Example 1, which has a thin p-type layer, has a high average light emission output and a small standard deviation (variation) between lots compared to the conventional example.

It should be noted that the embodiments disclosed in the present specification are for illustrative purposes, and that embodiments of the present disclosure are not limited thereto and can be modified as appropriate to the extent that they do not deviate from the object of the present disclosure.

### INDUSTRIAL APPLICABILITY

The present disclosure is applicable for an ultraviolet light-emitting element and a method of producing the same.

### REFERENCE SIGNS LIST

- 1: substrate
- 11: AlN layer
- 100: light-emitting element (ultraviolet light-emitting element)
- 2: buffer layer
- 21: first buffer layer
- 22: second buffer layer
- 3: n-type semiconductor layer
- 31: n-type guide layer
- 4: light-emitting layer (quantum well-type light-emitting layer)
- 41: well layer
- 42: barrier layer
- 5: i-type guide layer
- 6: p-type electron blocking layer
- 7: p-type cladding layer
- 8: p-type contact layer (p-type GaN contact layer)
- 91: p-side electrode
- 92: n-side electrode

## Claims

1. An ultraviolet light-emitting element comprising, in stated order:
an n-type semiconductor layer formed of AlₓGa₁₋ₓN having an Al composition ratio x;
a quantum well-type light-emitting layer;
a p-type electron blocking layer formed of Al_{y}Ga_{1-y}N having an Al composition ratio y;
a p-type cladding layer formed of Al_{z}Ga_{1-z}N having an Al composition ratio z; and
a p-type GaN contact layer, wherein
the Al composition ratio y of the p-type electron blocking layer is not less than 0.35 and not more than 0.45,
a thickness of the p-type electron blocking layer is not less than 11 nm and not more than 70 nm,
a total thickness of the p-type electron blocking layer and the p-type cladding layer is not less than 73 nm and not more than 100 nm, and
a thickness of the p-type GaN contact layer is not less than 5 nm and not more than 15 nm.

2. The ultraviolet light-emitting element according to claim 1, wherein
a surface of the p-type GaN contact layer has:
a maximum surface roughness of 9 nm or less; and
an average surface roughness of 1 nm or less.

3. The ultraviolet light-emitting element according to claim 1 or 2, wherein the Al composition ratio z of the p-type cladding layer is not less than 0.17 and not more than 0.27.

4. The ultraviolet light-emitting element according to claim 1 or 2, wherein a value obtained by dividing a thickness of the p-type cladding layer by the thickness of the p-type electron blocking layer is 0.4 or more.

5. The ultraviolet light-emitting element according to claim 1 or 2, wherein a surface of the n-type semiconductor layer has an average surface roughness of 1 nm or less.

6. The ultraviolet light-emitting element according to claim 1 or 2, wherein the n-type semiconductor layer has a full width at half maximum for (10-12) planes according to X-ray diffraction of 350 seconds or less.

7. The ultraviolet light-emitting element according to claim 1 or 2, wherein
the Al composition ratio x of the n-type semiconductor layer is not less than 0.2 and not more than 0.35, and
the Al composition ratio z of the p-type cladding layer is not more than the Al composition ratio x of the n-type semiconductor layer.

8. The ultraviolet light-emitting element according to claim 1 or 2, further comprising a reflective electrode, wherein the reflective electrode is disposed on a surface of the p-type GaN contact layer at an opposite side thereof to a surface at a side facing toward the p-type cladding layer.

9. The ultraviolet light-emitting element according to claim 1 or 2, having a central emission wavelength of not less than 331 nm and not more than 349 nm.

10. A method of producing an ultraviolet light-emitting element comprising:
an n-type semiconductor layer formation step of forming an n-type semiconductor layer formed of AlₓGa₁₋ₓN having an Al composition ratio x;
a light-emitting layer formation step of forming a quantum well-type light-emitting layer;
a p-type electron blocking layer formation step of forming a p-type electron blocking layer formed of Al_{y}Ga_{1-y}N having an Al composition ratio y;
a p-type cladding layer formation step of forming a p-type cladding layer formed of Al_{z}Ga_{1-z}N having an Al composition ratio z; and
a p-type GaN contact layer formation step of forming a p-type GaN contact layer, wherein
the n-type semiconductor layer formation step, the light-emitting layer formation step, the p-type electron blocking layer formation step, the p-type cladding layer formation step, and the p-type GaN contact layer formation step are performed in stated order,
the p-type electron blocking layer formation step:
sets the Al composition ratio y as not less than 0.35 and not more than 0.45; and
sets a thickness of the p-type electron blocking layer as not less than 11 nm and not more than 70 nm,
the p-type electron blocking layer formation step and the p-type cladding layer formation step set a total thickness of the p-type electron blocking layer and the p-type cladding layer as not less than 73 nm and not more than 100 nm, and
the p-type GaN contact layer formation step sets a thickness of the p-type GaN contact layer as not less than 5 nm and not more than 15 nm.

11. The method of producing an ultraviolet light-emitting element according to claim 10, wherein
the p-type GaN contact layer formation step:
sets a maximum surface roughness of a surface of the p-type GaN contact layer as 9 nm or less; and
sets an average surface roughness of the surface of the p-type GaN contact layer as 1 nm or less.

12. The method of producing an ultraviolet light-emitting element according to claim 9 or 10, further comprising a p-side electrode formation step of forming a p-side electrode on the p-type GaN contact layer.
